(19) Europäisches Patentamt / European Patent Office / Office européen des brevets

(11) **EP 4 318 829 A1**

(12) **EUROPEAN PATENT APPLICATION**

(43) Date of publication:
**07.02.2024  Bulletin 2024/06**

(21) Application number: **23189991.5**

(22) Date of filing: **07.08.2023**

(51) International Patent Classification (IPC):
**H01S 5/02212** (2021.01)    **H01S 5/02345** (2021.01)
**H01S 5/062** (2006.01)

(52) Cooperative Patent Classification (CPC):
**H01S 5/02212; H01L 24/00; H01S 5/02345;**
H01L 23/045; H01S 5/02218; H01S 5/02255;
H01S 5/02315; H01S 5/06226

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **05.08.2022  US 202263370497 P**

(71) Applicant: **Arima Lasers Corp.**
**324 Taoyuan City (TW)**

(72) Inventor: **MI, CHUN-WEI**
**333 Taoyuan City (TW)**

(74) Representative: **Michalski Hüttermann & Partner**
**Patentanwälte mbB**
**Kaistraße 16A**
**40221 Düsseldorf (DE)**

(54) **ELECTRONIC COMPONENT PACKAGE AND THE MANUFACTURING METHOD THEREOF**

(57)    The present invention relates to a new electronic component package and its manufacturing method, especially the package of an optoelectronic component. The package comprises an electronically conductive base, an electronically conductive cap, and at least one electronic component. The base has an upper surface, a lower surface, and at least one through hole sealed with a conducting feedthrough surrounded by a ring of insulating material. The electronic component is fixed on the upper surface of the base and is electrically connected to the conducting feedthroughs and/or the base. The base and the cap are sealed by welding.

FIG. 2A

EP 4 318 829 A1

**Description**

BACKGROUND OF THE INVENTION

Field of the Invention

The present invention relates to an electronic component package and its manufacturing method, especially the package of an optoelectronic component.

Description of Related Art

The packaging form is a crucial part for an electronic component, including semiconductor laser. It not only needs to consider the applicability of the chip, but also directly affects the application field and usage of the product. Even when utilizing the same chip, a good package design can make products with better performance and reliability, and therefore provide a better user experience.

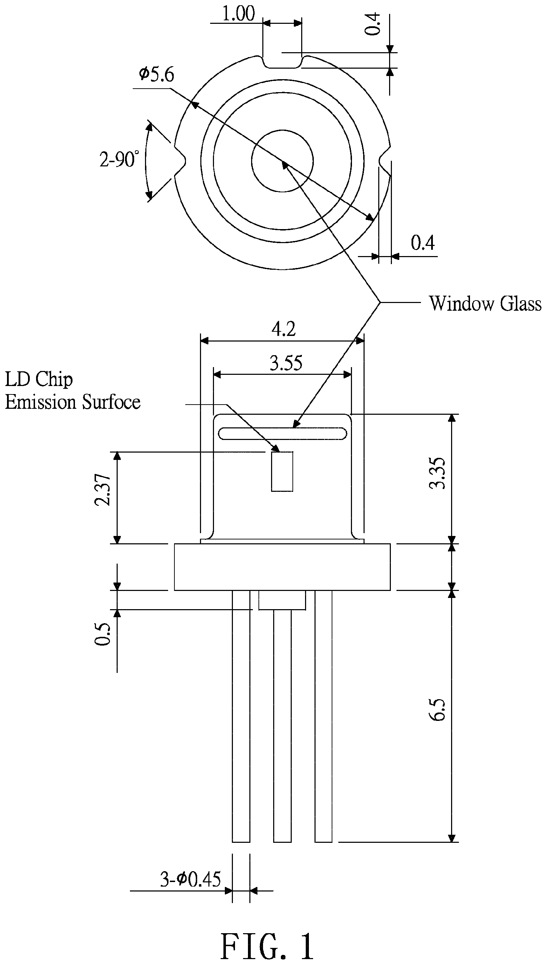

Semiconductor lasers are commonly packaged in the form of transistor outline (TO), chip on submount, or surface mount device (SMD). Among them, TO packaging is the mainstream packaging method due to its airtight metal shell structure, reliability, and mass production capability. At present, the most commonly used TO package semiconductor laser is TO56 with a diameter of 5.6 mm. Because of its long history of usage, the manufacturing process of TO package has become quite mature in terms of reliability and mass production. FIG. 1 is a schematic diagram showing a standard semiconductor laser TO package. Its structure is mainly composed of a flat-cylinder metal base with leads, a cylindrical upper cover, and a laser chip. Generally, the most typical design is three leads with a length of 6.5 mm. The total length including the base and the top cover is about 10 mm. In addition to the 5.6 mm diameter form, there are also other different specifications with diameter of 3.5 mm, 9.0 mm or larger. Apart from size, there are no significant differences in structure between those specifications.

However, the TO package also has the disadvantage of being large in size and can only be used in a plugin mode. The limitations of this package form are obvious in several aspects. First, the TO package form adopts lead plugin for power supply, which is larger in size and takes up more space. Under the current trend of pursuing miniaturization, traditional TO packaging will become increasingly unfavorable. Second, since global labor costs are rising day by day, it is inevitable for manufacturers to move toward automated assembly. The automatic packaging of the surface mount technology has advantages in efficiency and cost compared with the soldering of the plugin. Third, the soldering of the plugin makes it more difficult to dissipate heat from the package body, which limits the operating temperature of the product. Therefore, it is desired to develop a new packaging design to resolve the above issues.

SUMMARY OF THE INVENTION

The present invention provides a new electronic component package and its manufacturing method. The new design combines the concepts of TO packaging and surface mount device to create a new type of packaging, which is named "SM-TO" hereinafter. In preferred embodiment, a metal base with a substantially flat bottom is provided in the present invention, which may combine with a thin metal top cap by welding. In SM-TO package, the electronic component is fixed in the inner space of the metal base and the top cap. In this way, the package body can be actively miniaturized on the premise that the package structure is all metal. Because there are no leads (feedthroughs) protruding out from the plane of the metal base, users are allowed to use the surface mount technology to carry out subsequent processes, which greatly enhances the convenience of use, space requirements, and heat dissipation of the products.

One aspect of the present invention is to provide a base for electronic component packaging, comprising an upper surface, a lower surface defining a lamination plane, and at least one through hole, wherein the lamination plane is a virtual plane having the largest contacting area to the lower surface. The base is essentially made up of electrically conductive materials, each of the at least one through hole is sealed with a conducting feedthrough surrounded by a ring of insulating material, and both the conducting feedthrough and the ring of insulating material are not protruding from the lamination plane. In a preferred embodiment, the base is essentially made up of metal.

In one embodiment, the upper surface is substantially flat; in another embodiment, the upper surface is recessed inward at the center region.

The shape of the lower surface may be with any shape provided that the base may be placed stably with the lamination plane and well-mounted. In one embodiment, the lower surface is substantially flat; in another embodiment, the lower surface is recessed at the regions surrounding the feedthroughs; in yet another embodiment, the lower surface is recessed at the center region.

In one embodiment, the lowest end of the conducting feedthrough is on the lamination plane.

In one embodiment, the base comprises two through holes and two conducting feedthroughs, each of the two through holes is sealed with one conducting feedthrough surrounded by a ring of insulating material.

In one embodiment, the cross-sectional area of each of the feedthroughs is less than 1% of the area of the base. In one preferred embodiment, the base is substantially round shaped, the diameter of the base is about 5.6 mm, and the diameter of the feedthrough is about 0.45 mm.

In one modified embodiment, the base further comprises an elevation on the upper surface. In this embodiment, the two feedthroughs may be with different lengths on the upper-surface side.

Another aspect of the present invention is to provide an electronic component package, which comprises a base, a cap, and at least one electronic component, wherein the base and the cap are essentially made up of electrically conductive materials, and preferably made up of metals. The base has an upper surface and a lower surface. The lower surface defines a lamination plane, which is a virtual plane having the largest contacting area to the lower surface. The electronic component is fixed on the upper surface. In addition, the base has one or more through holes sealed with conducting feedthroughs surrounded by insulating materials, and the conducting feedthroughs and the insulating materials are not protruding from the lamination plane. The at least one electronic component is electrically connected to the conducting feedthroughs and/or the base. Lastly, the base and the cap are sealed by welding, which includes but not limited to resistance welding and laser welding. In a preferred embodiment, the upper surface is recessed inward at the center, and the at least one electronic component is fixed on the recessed part of the upper surface. In one embodiment, the lower surface is substantially flat.

In one embodiment, the electronic component is an optoelectronic component which can emit or receive light, and the cap has an opening in the center sealed by a transparent material to enable the passage of light. In one embodiment, the package further comprises one or more optical component fixed on the upper surface to alter the path of light. The optical component may be a geometric optical component such as a reflective prism.

In one embodiment, the electronic component is mounted on the metal base, and is connected to the conducting feedthroughs through one or more wires. In a preferred embodiment, the wires are gold wires.

In one embodiment, the conducting feedthroughs and the insulating materials of the feedthroughs in the electronic component package are not protruded from the lamination plane.

Yet another aspect of the present invention is to provide a method for electronic component package, which comprises the steps of: (1) providing an electrically conductive base having an upper surface and a lower surface; (2) providing an electrically conductive cap; (3) fixing at least one electronic component on the upper surface; and (4) sealing the base and the cap by welding. The lower surface of the electrically conductive base defines a lamination plane, which is a virtual plane having the largest contacting area to the lower surface. The base has one or more through holes sealed with conducting feedthroughs surrounded by insulating materials, and the conducting feedthroughs and the insulating materials are not protruding from the lamination plane. The welding method may be resistance welding or laser welding. The electronically conductive base and cap are preferably made up of metals.

In a preferred embodiment, the at least one electronic component is an optoelectronic component which can emit or receive light, and the cap has an opening in the center, wherein the opening is sealed by a transparent material.

In one embodiment, the method for electronic component package further comprising fixing one or more optical component on the upper surface to alter the path of light before sealing the base and the cap. In one embodiment, the optical component is a reflective prism.

Other objectives, advantages and novel features of the invention will become more apparent from the following detailed description when taken in conjunction with the accompanying drawings.

BRIEF DESCRIPTION OF THE DRAWINGS

FIG. 1 is the size specification of common TO-56 packaged laser diode with a diameter of 5.6 mm. The numbers denoting lengths in the figure are in the unit of millimeter (mm).

FIGS. 2A (perspective view), 2B (top view) and 2C (lateral sectional view) shows the structure of the base for SM-TO package. FIG. 2D shows the materials made up of the base in one embodiment. The numbers denoting lengths in the figure are in the unit of millimeter (mm).

FIGS. 3A (a perspective view) and 3B (a lateral sectional view) show examples of the lower surface of the base for SM-TO package. FIG. 3C shows the lower surface and the lamination plane.

FIGS. 4A (perspective view) and 4B (lateral sectional view) shows the structure of the base for SM-TO package in a modified embodiment.

FIGS. 5A (exploded view) and 5B (bottom view) shows the structure of SM-TO package, which comprises a base, a cap, and an electronic component.

FIGS. 6A (exploded view) and 6B (bottom view) shows the structure of SM-TO package for optoelectronic component. The electronic component is optoelectronic component which emits or receives light, and the cap has an opening sealed by transparent material at the center.

FIG. 7A shows the three-view drawing of SM-TO package before capping, and FIG. 7B shows the three-view drawing of SM-TO package after cap sealing.

FIG. 8 is a process flow chart showing the manufacturing process of TO package for optoelectronic component.

FIG. 9 is a process flow chart showing the manufacturing process of SMD package for optoelectronic component.

FIG. 10 is a process flow chart showing the manufacturing process of SM-TO package for optoelectronic component.

## DETAILED DESCRIPTION OF PREFERRED EMBODIMENTS

The terminology used in the description presented below is intended to be interpreted in its broadest reasonable manner, even though it is used in conjunction with a detailed description of certain specific embodiments of the technology. Certain terms may even be emphasized below; however, any terminology intended to be interpreted in any restricted manner will be specifically defined as such in this Detailed Description section.

In the present application, an electronic component package and the manufacturing method thereof are provided. The new design for the electronic component package is especially useful in the package of semiconductor lasers, however it can also be used in other kinds of electronic components.

Structure of the Base for SM-TO Package

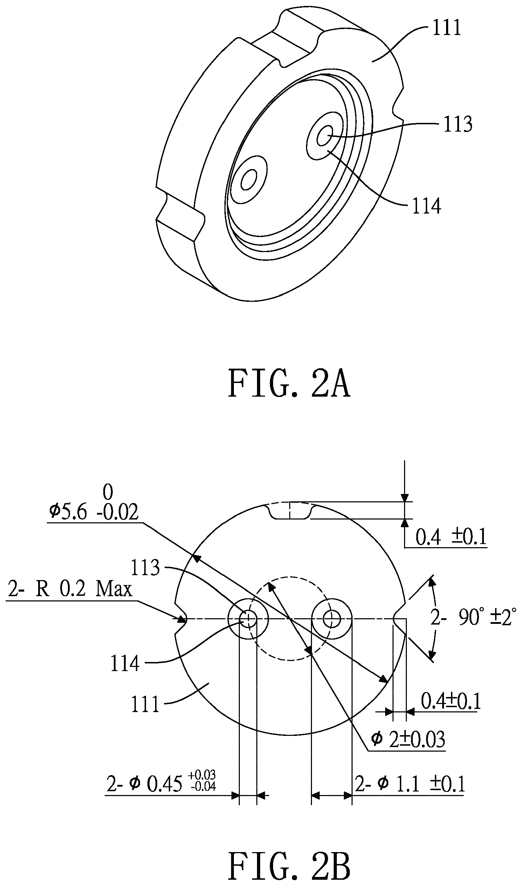

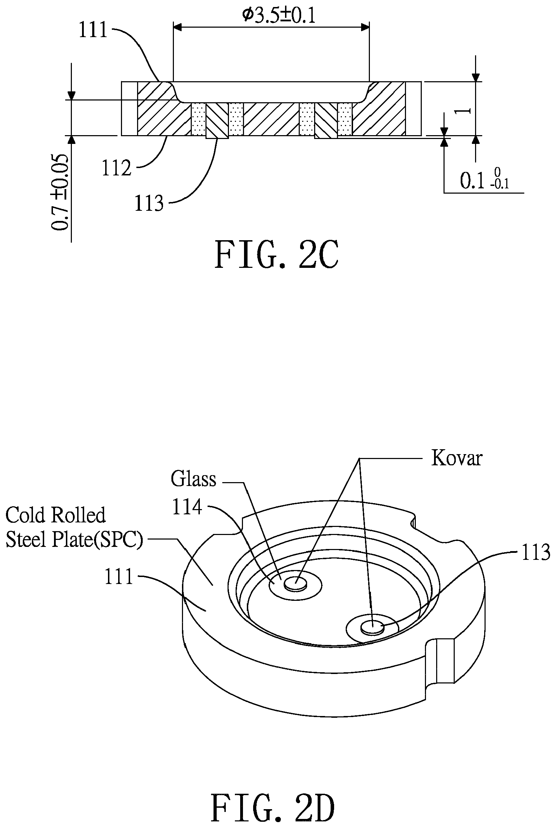

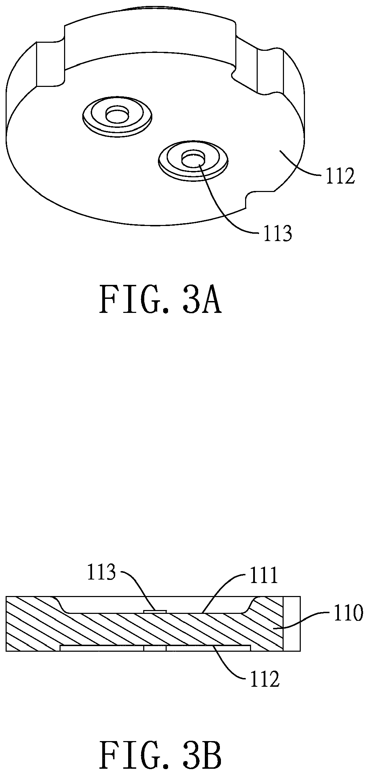

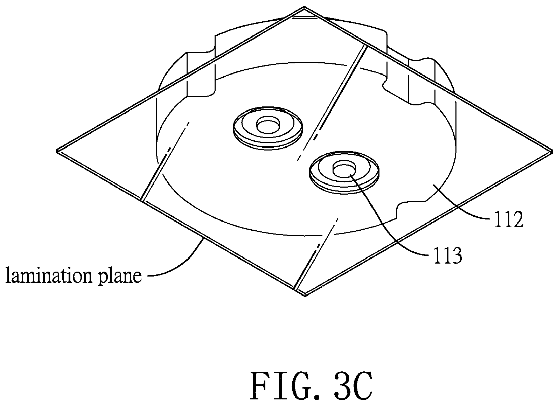

The structure of the base for SM-TO package is shown in FIG. 2A (perspective view), FIG. 2B (top view) and FIG. 2C (lateral sectional view). The base 110 is made up of electrically conductive material(s), preferentially metal material(s). The base 110 has an upper surface 111 and a lower surface 112. The upper surface 111 may be with any shape if the shape does not hinder sealing of the cap and the base. Examples include a flat upper surface, or an upper surface recessed-inward at the center region as shown in FIG. 2A. The shape of the lower surface 112 may be flat, or it may be with other shape (e.g. recessed inward at some part), provided it does not hinder surface mounting. Examples include but not limited to a design with a lower surface recessed at the regions surrounding the feedthroughs as shown in FIG. 3A, or a lower surface recessed at the center region as shown in FIG. 3B. More generally, the lower surface 112 defining a lamination plane, which is a virtual plane having the largest contacting area to the lower surface, as shown in FIG. 3C. The shape of the lower surface 112 may be with any shape provided that the base may be placed stably with the lamination plane and well-mounted on a printed circuit board (PCB). In the embodiment as shown in FIG. 2C, the lower surface 112 is substantially flat. The base 110 also comprises at least one through hole, each of which is sealed with a conducting feedthrough 113 surrounded by a ring of insulating material 114. The feedthroughs 113 are electrically separated from the base 110, and enable electrical connection between two sides of the base 110 via the conducting materials make up the feedthroughs 113. In one preferred embodiment as shown in FIG. 2D, the base 110 is made up of cold rolled steel (SPC), the feedthrough 113 is made up of nickel-cobalt ferrous alloy having substantially the same thermal expansion characteristics as glass (such as Kovar® alloy), and the insulating material 114 is made up of glass materials. In some specific embodiments, there are two through holes on the base 110. For the purpose of surface mounting, both the conducting feedthroughs 113 and the rings of insulating material 114 are not protruding from the lamination plane. In a preferred embodiment, the lowest ends of the conducting feedthroughs 113 are on the lamination plane. However, when fabricating the package, the feedthrough 113 and/or the insulating material 114 might be slightly bulged from the lower surface 112 due to precision issue. This does not affect the use of the package, providing that the lowest ends of the conducting feedthroughs 113 and/or the insulating materials 114 are substantially on the lamination plane. For example, as shown in FIG. 2C, a small deviation of (+0/-0.1) mm is allowable in a package with a diameter of 5.6 mm.

In the embodiment as shown in FIGS. 2A-2C, the base 110 has two through holes with feedthroughs 113 therein. The base is substantially round shaped. The diameter of the base 110 is 5.6 mm, the diameter of the feedthroughs 113 is about 0.45 mm, and the height of the feedthroughs 113 (within the through hole region) is about 0.7 mm to 1.0 mm. The size of the feedthroughs 113 is smaller than the feedthrough size of conventional surface-mount device (SMD) packages. The cross-sectional area of each feedthrough 113 in this embodiment are less than 1% of the area of the base 110.

The design described above aims to reduce the resistance and capacity of the feedthroughs 113 at the same time. The resistance and capacity of the feedthroughs have a great influence on transmitting or receiving electronic signals. The higher the resistance and capacity, the longer the rise/fall time of electronic signals. When transmitting/receiving high-frequency electronic signals, a too long rise/fall time will lead to insufficient signal integrity. For example, in high-frequency optical communication applications, a too long rise/fall time will result in a smaller eye pattern, making the transmitted signals prone to errors. The resistance of metal wire(s) is given by the relation $R = \rho \dfrac{l}{A}$ , wherein $R$

is resistance of wire, $\rho$ is resistivity, $l$ is wire length, and $A$ is cross-sectional area of wire. The capacity of a pair of parallel wires is given by the relation $C = \dfrac{2\pi\varepsilon l}{\cosh^{-1}\left(\dfrac{d^2-2a^2}{2a^2}\right)}$ , wherein $C$ is capacity of the pair of parallel wires, $\varepsilon$ is permittivity between the wires, $l$ is length of the wires, $d$ is distance between the wires, and $a$ is radius of the wires. It can be seen from the above formulae that reducing both the length and the diameter of the feedthroughs 113 can reduce the resistance and capacity thereof at the same time, and thus is beneficial in minimizing the rise/fall time.

The diameter of the through holes (which is the regions with the insulating materials 114) in the embodiment shown in FIGS. 2A-2C is about 1.1 mm. In comparison, traditional TO-56 package has leads (feedthroughs) with diameter of insulation regions designed to be 1.0 mm. The insulating regions in this embodiment is larger than that of corresponding TO-56 package. The insulation design of smaller insulating region works normally when it is used in lead plugin process on printed circuit board (PCB). However, in surface mount process, if the insulating area is too small, the solder at the leads may overflow and short circuit with the base body 110. To solve this problem, the insulating area is enlarged to a diameter of 1.1 mm to reduce the risk of short circuit. This feature enables the package to be used as an SMD.

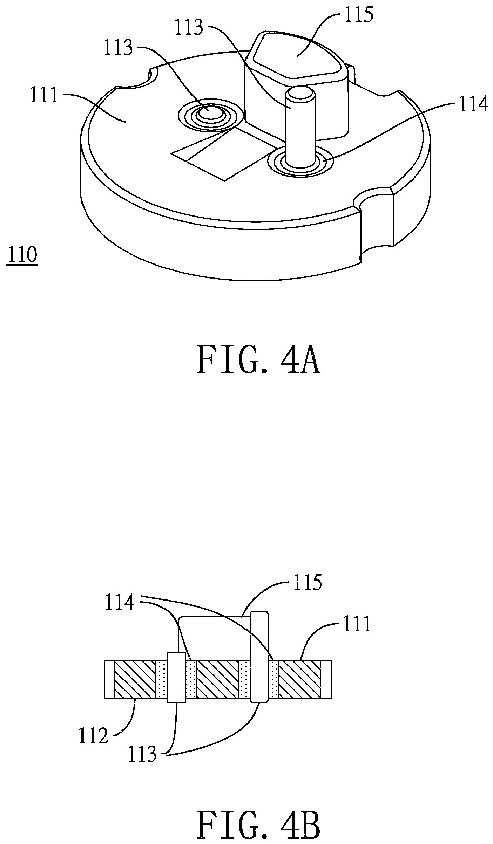

In a modified embodiment as shown in FIG. 4A, the base 110 comprises an elevation 115 on the upper surface 111. The elevation 115 is to enable an edge emitting laser (EEL) to emit a light beam perpendicular to the base when the EEL is attached to the side face of the elevation 115. With this design, no reflective prism is required in complete SM-TO package. Also, the two feedthroughs 113 may be with different lengths on the upper-surface side, as shown in FIGS. 4A-4B. This design makes wire bonding between feedthroughs 113 and the attached EEL easier.

Structure of SM-TO Package

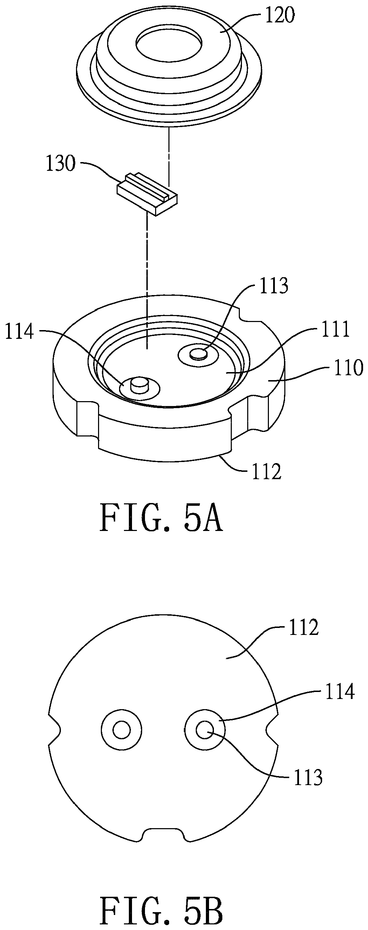

The structure of SM-TO package disclosed in this application is shown in FIG. 5A (top view) and FIG. 5B (bottom view). The SM-TO package 100 comprises a metal base 110, an upper cap 120, and an electronic component 130. The metal base has an upper surface 111 and a lower surface 112, wherein the lower surface 112 is substantially flat, as shown in FIG. 5B. The upper surface 111 may be any shape if the shape does not hinder sealing of the cap and the base. In one embodiment as shown in FIG. 5A, the upper surface 111 is recessed inward at the center region. As such, the recess on the upper surface can accommodate the electronic component 130, and the packaged product can be closely disposed on the surface of a circuit board to minimize its size. The metal base 110 also has one or more feedthroughs 113 with conducting materials surrounded by insulating materials 114. The feedthroughs 113 are electrically separated from the metal base 110, and enable electrical connection between two sides of the metal base 110 by the conducting materials make up the feedthroughs 113. The shape of the lower surface 112 may be flat, or it may be with other shape (e.g. recessed inward at some part), provided it does not hinder surface mounting. Examples include but not limited to a design with a lower surface recessed at the regions surrounding the feedthroughs, as shown in FIG. 3A, or a lower surface recessed at the center region, as shown in FIG. 3B. The electronic component 130 is fixed on the recessed part of the upper surface 111, and is electrically connected to the metal base 110 and/or one or more feedthroughs 113 individually. In the case where a diode is used as the electronic component 130, at least one feedthrough 113 is required; and if a transistor is used as the electronic component 130, at least two feedthroughs 113 are required for this setting. Finally, the metal base 110 and the metal cap 120 are sealed by welding. Commonly used methods for sealing the conducting materials together include but not limited to resistance welding and laser welding.

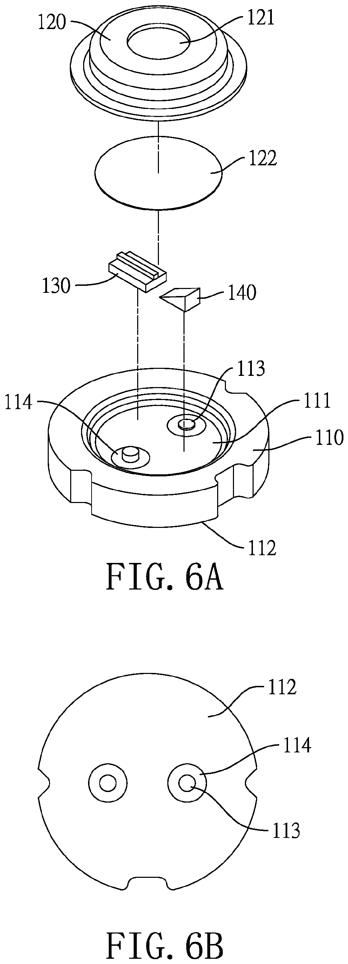

A preferred embodiment of SM-TO package is shown in FIGS. 6A and 6B. In this embodiment, the SM-TO package 100 is utilized for the packaging of an optoelectronic component 130. An optoelectronic component is an electronic component which can emit or receive light, such as a laser chip. The wavelength of the light to be emitted or received may be chosen according to the needs. This includes but not limited to infrared, visible light, and ultraviolet. In order to fit the functionalities of an optoelectronic component, the metal cap 120 comprises an opening 121 at the center to enable the passage of light. To provide air tightness of the package, the opening of the metal cap 121 is sealed with a transparent material 122. The opening of the cap 121 may be sealed by resistance soldering, laser soldering, or other sealing methods. The transparent material 122 sealing the opening 121 may be selected based on the wavelength of light designed to be emitted or received by the optoelectronic component 130. Commonly used substrate materials mostly comprise $SiO_2$ as major chemical component, such as glass, quartz, etc.. However, other materials which are transparent to selected wavelength interval may also be used. Besides the substrate, one or more layers of coating are usually applied. In the selection of coating for the transparent material 122, the dielectric multi-layer method is used, and the thickness and number of layers are adjusted according to the wavelength to achieve the best penetration coefficient. Examples include but not limited to dielectric multilayer coatings such as interlaced $SiO_2$ films and $Al_2O_3$ films. By adjusting the chemical composition, thickness and number of layers, a material with high transmittance, reflectivity or absorbance for various wavelengths can be produced.

In one example of the preferred embodiment, the optoelectronic component 130 is one or more laser chips. In addition, suitable photodiodes (PD) and auto power control IC (APC-IC) can be added according to the type of laser chip as output stability control components. In a modified version, a photodetector chip may be used along with or in place of the laser chip. The material of the base 110 is a metal with gold-plated on its surface. The conducting feedthroughs 113 on the base 110 are fixed and insulated from the base by glass glue sintering, and the height of the conducting feedthroughs 113 on the lower surface 112 of the base is the same as that of the metal base 110 itself, so that the feedthroughs 113 are not extended from the bottom of the base 110. The center of the base on the upper surface 111 is designed to be recessed inward to ensure the structural strength of the base material and the positional stability during processing while reducing the volume of the package. The structure of the cap 120 is a metal shell with an opening 121 at the center, and the region of the opening 121 is bonded with a transparent material 122 (such as glass), so that light can pass through the cap 120. This packaging method can be applied to at least two types of products, edge emitting laser (EEL) and vertical-cavity surface-emitting laser (VCSEL), both of which are common in semiconductor lasers. When using EEL, an optical component 140, such as a reflective prism, can be added to alter the path of light. In such, via the optical component 140, the light beam becomes perpendicular to the base 110 and passes through the transparent material 122 of the cap 120. The type of coating on the surface of the optical component 140 is selected mainly based on the wavelength of light. For an optical component like a reflective prism, aluminum is commonly used as high reflective coating material in visible wavelength, and gold or dielectric multilayer are used as reflective coating material in infrared wavelength.

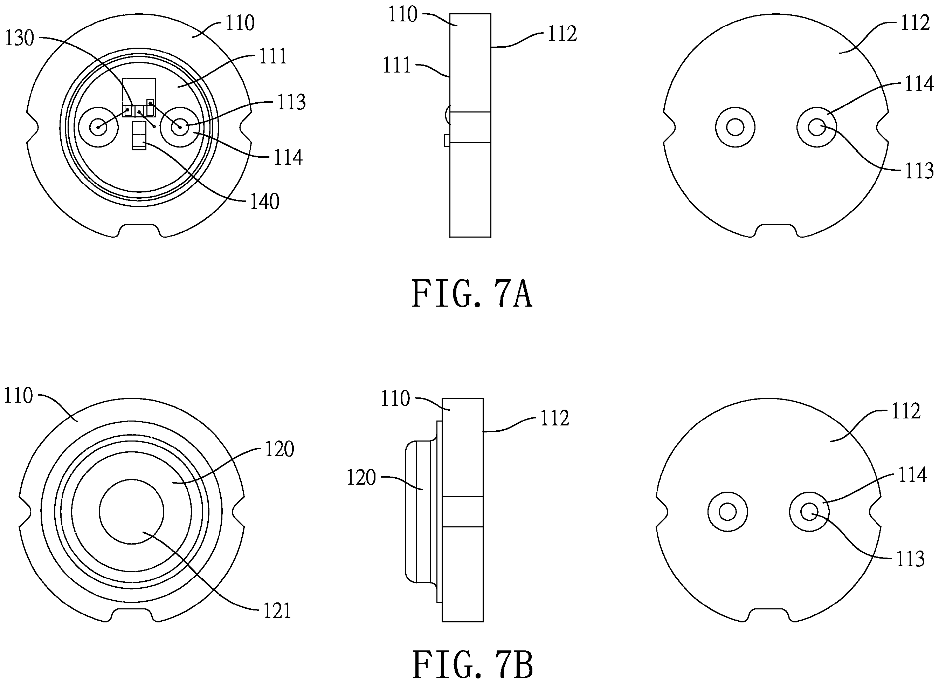

This packaging method can carry out single or multiple laser chips in a single package, and the wavelength of the laser is not limited. The shape of the package can be round or any other suitable shapes. FIG. 7A and FIG. 7B shows the three-view drawing of SM-TO package before (FIG. 7A) and after (FIG. 7B) cap sealing.

Manufacturing of SM-TO Package

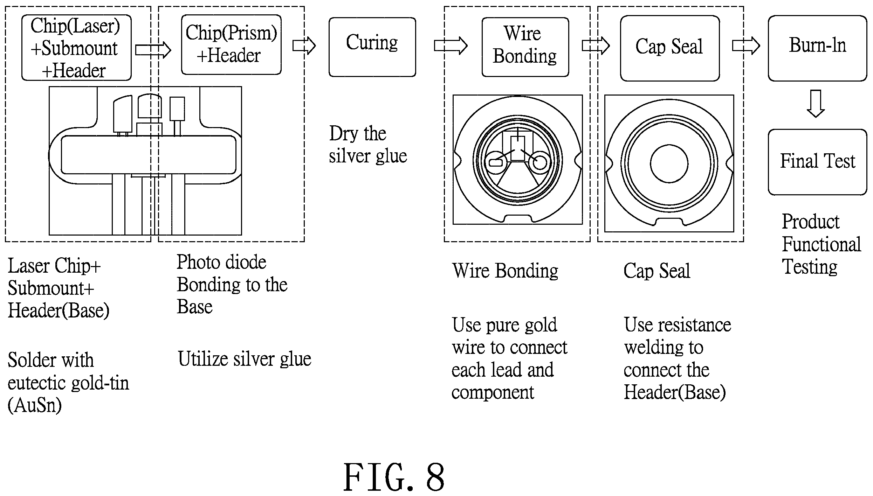

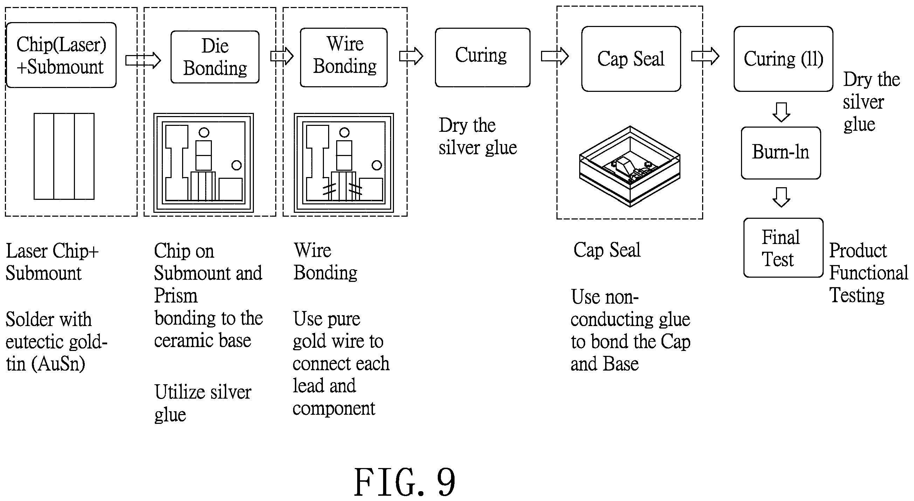

Traditionally, two forms of packages are commonly used on semiconductor laser packaging, namely transistor outline (TO) and surface mount device (SMD). The exemplary flow charts showing the manufacturing process of TO packaging and SMD packaging are as shown in FIG. 8 and FIG. 9, respectively. In short, TO packaging uses resistance welding as the cap-sealing mean, which provides higher airtightness than adhesive bonding. However, the feedthroughs (leads) protruding from the base of TO package prevent it from surface-mounting applications. On the other hand, SMD packaging is designed for surface mounting, but it usually utilizes glue to bind the non-conducing cap and base, which limits its airtightness. When a hermetic seal is required for SMD, laser welding is a widely adopted method, but it is slower and more expensive than resistance welding.

The SM-TO package provided in the present invention keeps the advantages of both TO and SMD packages. To manufacture the SM-TO package 100, the individual components (the base 110, the cap 120, the electronic component 130 and in some cases also the optical component 140) are prepared and then assembled. The package of the SM-TO 100 comprises the following steps: (1) chip bonding, (2) wire bonding, and (3) capping and sealing. In the chip bonding step, the electronic component 130 called chips or dice are attached to the base 110 using either an adhesive or a eutectic alloy. The wire bonding step making interconnects between the chip(s) 130 and its package is performed after chip bonding step. The wires used in wire bonding step may be made of gold, silver, copper, aluminum, or other conductive materials. When every component is attached to its correct position, the capping and sealing step is performed to close the package and protect the chip(s) inside. Using adhesives to bind the cap 120 and the base 110 is a common mean to seal the package. Alternatively, the package can be sealed by welding if both the cap 120 and the base 110 are conductive materials. In some embodiments of SM-TO package, a prism bonding step may also be included before capping to adhere an optical component 140, such as a reflective prism, on the base to alter the path of light, as shown in FIG. 6A.

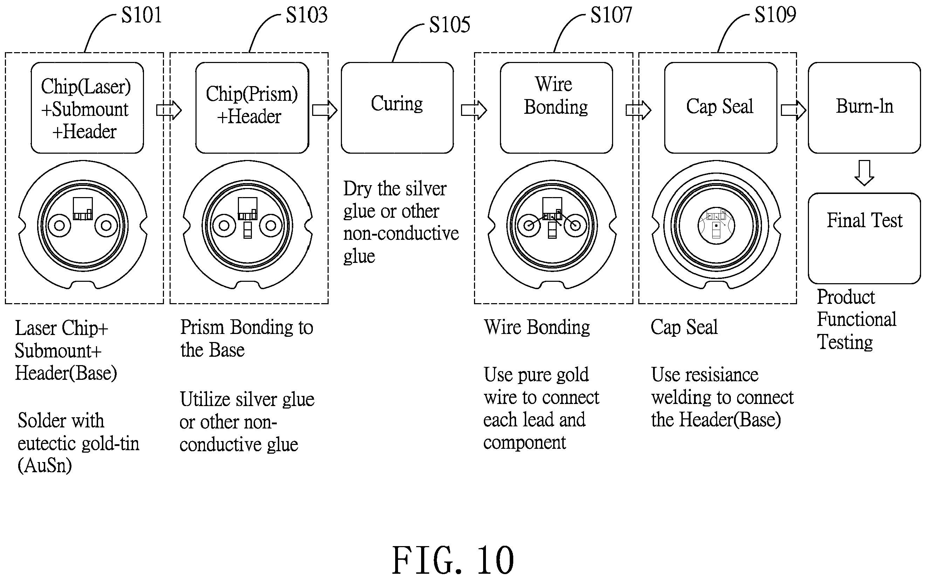

FIG. 10 is an exemplary flow chart showing the preferred process for manufacturing the SM-TO package, including a prism bonding step. Step S101 is chip bonding. Gold-tin (AuSn) alloy is used as the eutectic solder to bond the chip 130 on the base 110, which is a metal base. Step S103 is optical component bonding. Silver paste is used to fix the optical component 140 on the upper surface 111. Step S105 is curing step to dry the paste by heating and then cooling. Step S107 is wire bonding step, which uses pure gold wire to connect each lead (feedthrough) and each electronic component correctly. Ball bonding, wedge bonding and compliant bonding are some examples of commonly used wire bonding methods. The last step for packaging, S109, is cap seal. In this step, the metal base 110 and the metal cap 120 are welded together by resistance welding. To protect the components of the package from rusting, desiccated air or inert gases may also be used in the capping process. It should be noted that the order of some steps described above may be interchangeable, provided the leading steps do not hinder the following steps. For example, the wire bonding step may be directly after the chip bonding step.

Comparison of SM-TO with Other Traditional Packages

FIG. 2B and FIG. 2C shows the size of a metal base used in an SM-TO package corresponding to traditional laser diode package TO56. The diameter of the metal base is 5.6 mm, and the height is about 1 mm. The height of the metal cap is about 1 mm. For comparison, the package properties of SMD, TO (TO56) and SM-TO (SM-TO56) are provided below in Table 1.

Table 1: Comparison of SMD, SM-TO and TO packages

| Package Height | SMD~1.5 mm | SM-TO56-2 mm | TO56~3.5 mm (excluding lead pins) -10 mm (with lead pins) |
|---|---|---|---|
| SMT | Yes | Yes | No |
| Airtight | Not Airtight | Airtight | Airtight |

As shown in Table 1, the size of SM-TO package is greatly reduced compared to traditional TO package. Besides size reduction, another advantage of changing traditional transistor outline (TO) into SM-TO packaging is that surface-mount design facilitates heat dissipating and thus enables a higher operating temperature compared to traditional TO design. This can be shown by a real example provided below. Because the luminous power of laser is affected by heat, the luminous efficiency of laser will decrease when the temperature is higher due to poor heat dissipation. Therefore, the heat dissipation capability of different packages can be evaluated by comparing the luminous efficiency at the same temperature. In the evaluation, the same chip in TO and SM-TO packages with diameter of 5.6 mm are tested for comparison. When the same optical power of 7mW is achieved, the conventional TO requires 28mA of current and the SM-TO requires only 25mA. This result shows that the wall-plug efficiency is improved by 12% when using SM-TO design, indicating a better heat dissipating ability.

On the other hand, while slightly larger in height than SMD package, the SM-TO package of the present invention utilizes resistance welding to provide a higher air-tight level. Adhesive bonding is usually adopted for traditional SMD package to join the base and the cap, but it is hard to achieve satisfactory air-tight level comparable to welding methods. When a hermetic seal is required for SMD, laser welding is a widely adopted method, but it is slower and more expensive. Therefore, the SM-TO design is superior to SMD design for its better airtightness, especially when considering the price in mass production.

In summary, the present disclosure provides a new SM-TO package with high airtightness and relatively small package size. The package product is a small-size electronic component suitable for surface mount technology, which is advantageous over traditional TO package for its lower cost and higher production speed when applied on printed circuit board. When comparing to traditional SMD, SM-TO provides a reliable, relatively inexpensive and fast packaging process for hermetic seal. Thus, the features of SM-TO are ideal for miniaturized devices and/or applications in harsh environments. Examples include but not limited to chips for portable devices, chips operating in harsh or industrial environments, and laser chips for automobiles.

The foregoing description of embodiments is provided to enable any person skilled in the art to make and use the subject matter. Various modifications to these embodiments will be readily apparent to those skilled in the art, and the novel principles and subject matter disclosed herein may be applied to other embodiments without the use of the innovative faculty. The claimed subject matter set forth in the claims is not intended to be limited to the embodiments shown herein but is to be accorded the widest scope consistent with the principles and novel features disclosed herein. It is contemplated that additional embodiments are within the scope of the disclosed subject matter. Thus, it is intended that the present invention covers modifications and variations that come within the scope of the appended claims and their equivalents.

Reference Signs:

110    Base
111    Upper surface
112    Lower surface
113    Feedthrough
114    Insulating material
115    Elevation
120    Cap

121     Opening
122     Transparent material
130     Electronic component
140     Optical component

**Claims**

1. A base for electronic component packaging, comprising:

   an upper surface;
   a lower surface defining a lamination plane; and
   at least one through hole; wherein
   the base is essentially made up of electrically conductive materials;
   the lamination plane is a virtual plane having the largest contacting area to the lower surface; and
   each of the at least one through hole is sealed with a conducting feedthrough surrounded by a ring of insulating material, and both the conducting feedthrough and the ring of insulating material are not protruding from the lamination plane.

2. The base of claim 1, wherein the base is essentially made up of metal.

3. The base of claim 1, wherein the upper surface is recessed inward at the center region, and/or wherein the lower surface is substantially flat.

4. The base of claim 1, wherein the lowest end of the conducting feedthrough is on the lamination plane.

5. The base of claim 1, wherein the base comprises two through holes and two conducting feedthroughs, and wherein preferably the cross-sectional area of each of the feedthroughs is less than 1% of the area of the base, and wherein further preferably the base is substantially round shaped, the diameter of the base is about 5.6 mm, and the diameter of the feedthrough is about 0.45 mm.

6. The base of claim 1, further comprising an elevation on the upper surface.

7. An electronic component package, comprising:

   a base having an upper surface and a lower surface, and the lower surface defines a lamination plane;
   a cap; and
   at least one electronic component fixed on the upper surface; wherein
   the lamination plane is a virtual plane having the largest contacting area to the lower surface; the base has one or more through holes sealed with conducting feedthroughs surrounded by insulating materials;
   the conducting feedthroughs and the insulating materials are not protruding from the lamination plane;
   the at least one electronic component is electrically connected to the conducting feedthroughs and/or the base;
   the base and the cap are essentially made up of electrically conductive materials; and
   the base and the cap are sealed by welding.

8. The electronic component package of the previous claim, wherein the upper surface is recessed inward at the center, and the at least one electronic component is fixed on the recessed part of the upper surface, and/or wherein the lower surface is flat.

9. The electronic component package of claim 7, wherein the welding method is resistance welding or laser welding.

10. The electronic component package of claim 7, wherein:

    the cap has an opening at the center, the opening is sealed by a transparent material; and
    the at least one electronic component is an optoelectronic component which can emit or receive light.

11. The electronic component package of claim 7, wherein the electronic component is mounted on the base, and is connected to the conducting feedthroughs and/or the base through one or more wires, and wherein preferably the one or more wires are gold wires.

12. The electronic component package of claim 10, further comprising one or more optical components fixed on the upper surface to alter the path of light, and wherein preferably the one or more optical components is a reflective prism.

13. A method for electronic component package, comprising:

providing an electrically conductive base having an upper surface and a lower surface, wherein:

the lower surface defines a lamination plane, which is a virtual plane having the largest contacting area to the lower surface,
the base has one or more through holes sealed with conducting feedthroughs surrounded by insulating materials, and
the conducting feedthroughs and the insulating materials are not protruding from the lamination plane;

providing an electrically conductive cap;
fixing at least one electronic component on the upper surface; and
sealing the base and the cap by welding.

14. The method of claim 13, wherein the welding method is resistance welding or laser welding.

15. The method of claim 13, wherein:

the cap has an opening in the center, the opening is sealed by a transparent material; and
the at least one electronic component is an optoelectronic component which can emit or receive light, and wherein preferably
before sealing the base and the cap further comprising fixing one or more optical component on the upper surface to alter the path of light.

FIG. 1

FIG. 2A

FIG. 2B

111

φ3.5±0.1

0.7 ±0.05

112

113

1

0.1 $^{0}_{-0.1}$

## FIG. 2C

Kovar

Glass

Cold Rolled
Steel Plate(SPC)

114

111

113

## FIG. 2D

FIG. 3A

FIG. 3B

lamination plane

112

113

FIG. 3C

FIG. 4A

FIG. 4B

FIG. 5A

FIG. 5B

FIG. 6A

FIG. 6B

**FIG. 7A**

**FIG. 7B**

EP 4 318 829 A1

| Chip(Laser) +Submount +Header | Chip(Prism) +Header | Curing | Wire Bonding | Cap Seal | Burn-ln |

Laser Chip+ Submount+ Header(Base)

Solder with eutectic gold-tin (AuSn)

Photo diode Bonding to the Base

Utilize silver glue

Dry the silver glue

Wire Bonding

Use pure gold wire to connect each lead and component

Cap Seal

Use resistance welding to connect the Header(Base)

Final Test

Product Functional Testing

FIG. 8

Chip(Laser) +Submount ⇨ Die Bonding ⇨ Wire Bonding ⇨ Curing ⇨ Cap Seal ⇨ Curing (ll)

Dry the silver glue

⇩

Burn-ln

⇩

Final Test

Dry the silver glue

Product Functional Testing

Laser Chip+ Submount

Solder with eutectic gold-tin (AuSn)

Chip on Submount and Prism bonding to the ceramic base

Utilize silver glue

Wire Bonding

Use pure gold wire to connect each lead and component

Dry the silver glue

Cap Seal

Use non-conducting glue to bond the Cap and Base

# FIG. 9

S101     S103     S105     S107     S109

| Chip(Laser) +Submount +Header | Chip(Prism) +Header | Curing | Wire Bonding | Cap Seal | Burn-In |

Dry the silver glue or other non-conductive glue

Final Test

Laser Chip+ Submount+ Header(Base)

Solder with eutectic gold-tin (AuSn)

Prism Bonding to the Base

Utilize silver glue or other non-conductive glue

Wire Bonding

Use pure gold wire to connect each lead and component

Cap Seal

Use resisiance welding to connect the Header(Base)

Product Functional Testing

FIG. 10

Europäisches
Patentamt

European
Patent Office

Office européen
des brevets

**EUROPEAN SEARCH REPORT**

Application Number

EP 23 18 9991

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/228405 A1 (TATEIWA YOSHIHIRO [JP] ET AL) 4 October 2007 (2007-10-04) | 1-11, 13-15 | INV. H01S5/02212 H01S5/02345 |
| Y | * paragraphs [0019] - [0025], [0034] - [0038]; figures 1,4 * | 7-15 | |
| | ----- | | ADD. H01S5/062 |
| X | JP 2014 003062 A (MITSUBISHI ELECTRIC CORP) 9 January 2014 (2014-01-09) | 1-15 | |
| Y | * paragraphs [0011] - [0024]; figure 1 * | 7-15 | |
| | ----- | | |
| X | US 2005/194601 A1 (SUENAGA RYOMA [JP]) 8 September 2005 (2005-09-08) | 1-6 | |
| Y | * paragraphs [0044] - [0124]; figures 1-5 * | 7-15 | |
| | ----- | | |
| Y | US 4 733 067 A (OINOUE HIROSHI [JP] ET AL) 22 March 1988 (1988-03-22) * column 2, lines 15-39; figures 2,9 * * column 3, lines 50-58 * | 12 | |
| | ----- | | |

TECHNICAL FIELDS SEARCHED (IPC)

H01S

The present search report has been drawn up for all claims

| Place of search | Date of completion of the search | Examiner |
|---|---|---|
| Munich | 1 December 2023 | Laenen, Robert |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## EP 4 318 829 A1

### ANNEX TO THE EUROPEAN SEARCH REPORT
### ON EUROPEAN PATENT APPLICATION NO.

EP 23 18 9991

This annex lists the patent family members relating to the patent documents cited in the above-mentioned European search report.
The members are as contained in the European Patent Office EDP file on
The European Patent Office is in no way liable for these particulars which are merely given for the purpose of information.

01-12-2023

| Patent document cited in search report | | | Publication date | Patent family member(s) | | | Publication date |
|---|---|---|---|---|---|---|---|
| US 2007228405 | A1 | | 04-10-2007 | CN | 101047298 | A | 03-10-2007 |
| | | | | JP | 4772557 | B2 | 14-09-2011 |
| | | | | JP | 2007273521 | A | 18-10-2007 |
| | | | | US | 2007228405 | A1 | 04-10-2007 |
| JP 2014003062 | A | | 09-01-2014 | CN | 103515838 | A | 15-01-2014 |
| | | | | JP | 2014003062 | A | 09-01-2014 |
| US 2005194601 | A1 | | 08-09-2005 | JP | 3891115 | B2 | 14-03-2007 |
| | | | | JP | WO2002089219 | A1 | 19-08-2004 |
| | | | | US | 2004120155 | A1 | 24-06-2004 |
| | | | | US | 2005194601 | A1 | 08-09-2005 |
| | | | | WO | 02089219 | A1 | 07-11-2002 |
| US 4733067 | A | | 22-03-1988 | AT | E82438 | T1 | 15-11-1992 |
| | | | | AU | 584188 | B2 | 18-05-1989 |
| | | | | CA | 1258906 | A | 29-08-1989 |
| | | | | DE | 3687078 | T2 | 19-05-1993 |
| | | | | EP | 0199565 | A2 | 29-10-1986 |
| | | | | US | 4733067 | A | 22-03-1988 |

EPO FORM P0459